# EUROPÄISCHE PATENTSCHRIFT

(11) **EP 2 241 868 B1**
(45) Veröffentlichungstag und Bekanntmachung des Hinweises auf die Patenterteilung: **02.05.2018**
(21) Anmeldenummer: 10003662.3
(22) Anmeldetag: 01.04.2010
(51) Int. Cl.: G01F 23/26, G01D 5/24, G01R 27/26

(54) **Schaltungsanordnung zur Bestimmung einer Messkapazität**
Measuring circuit for determining a measuring capacity
Circuit destiné à la détermination d'une capacité de mesure

(30) Priorität: 14.04.2009 DE 102009017011
(43) Veröffentlichungstag der Anmeldung: 20.10.2010
(73) Patentinhaber: BALLUFF GmbH, 73765 Neuhausen (DE)
(72) Erfinder: Winkens, Frank, 67067 Ludwigshafen (DE)
(74) Vertreter: Jakelski & Althoff Patentanwälte PartG mbB

(56) Entgegenhaltungen:
- EP-A1- 1 862 806
- EP-A2- 0 908 736
- DE-A1- 10 156 580
- US-A- 4 459 541

## Beschreibung

Die Erfindung betrifft eine Schaltungsanordnung zur Bestimmung einer Messkapazität.

### Stand der Technik

Zur Messung sehr kleiner Kapazitäten bzw. Kapazitätsänderungen kommen beispielsweise kapazitive Näherungsschalter zum Einsatz, die seit dem Ende der sechziger Jahre bekannt sind. Sie arbeiten im Wesentlichen nach dem Prinzip der Beeinflussung eines elektrischen Wechselfeldes durch ein Dielektrikum eines Objektes oder Mediums, welches deutlich größer ist als das Dielektrikum von Luft oder Vakuum. Das Einbringen eines derartigen Dielektrikums in das Nahfeld einer oder mehrerer Messelektroden führt dort zu einer entsprechenden Konzentration der elektrischen Feldlinien und damit der Verstärkung des elektrischen Feldes. Hierdurch erhöht sich die Kapazität beispielsweise eines Kondensators, z.B. eines Plattenkondensators, zwischen dessen Platten das Dielektrikum eingebracht wird, um einen geringen Betrag. Diese Kapazitätsänderung wird in einer Auswerteschaltung ausgewertet. Beispielsweise wird ein Schaltsignal von der Auswerteschaltung ausgegeben, wenn die Kapazität einen vorgegebenen Wert überschreitet.

Derartige kapazitive Näherungsschalter kommen auf den vielfältigsten technischen Gebieten zum Einsatz. Sie finden z.B. Anwendung in der Überwachung von Grenzfüllständen von Medien aller Art, beispielsweise wässrigen Medien, Granulaten, Pulvern, Ölen und dergleichen. Dabei werden sie sowohl in ein Medium eintauchend zur Erfassung beispielsweise des Füllstandes eingesetzt als auch berührungslos, beispielsweise durch Anordnung außerhalb an einer nichtmetallischen Behälterwand, um z.B. den Füllstand in dem Behälter zu erfassen. Ein anderes Einsatzgebiet ist die Erfassung und Erkennung von Objekten über eine gewisse Distanz, beispielsweise die Erfassung eines Papierstapels, die Erfassung eines metallischen Gegenstandes, eines Glases und dergleichen.

Die kapazitiven Sensoren werden mit Hilfe elektronischer Schaltungen betrieben, deren Wirkungsweise sich hinsichtlich ihres Wirkungsprinzips in zwei Hauptgruppen aufteilen lässt.

Zum einen existieren oszillatorische Verfahren, bei denen in der Regel die Schwingungsbedingung eines Oszillators als rückgekoppelter Verstärker kurz vor dem Einsetzen der Schwingung über ein Elektrodensystem gesteuert wird. Das Elektrodensystem bildet hierbei meistens ein kapazitiver Spannungsteiler mit der Messkapazität als integralem Bestandteil. Die Höhe der Messkapazität beeinflusst den Gesamtverstärkungsfaktor, die Phasenlage und somit das Schwingungsverhalten. Derartige Oszillatorschaltungen zur Detektion kleiner Kapazitäten und Kapazitätsunterschiede zum Einsatz in kapazitiven Sensoren gehen beispielsweise aus der DE 101 56 580 A1 oder aus der DE 1 673 841 A1 hervor. Mit Hilfe solcher Schaltungen und Verfahren sind mit geringem schaltungstechnischem Aufwand hohe Empfindlichkeiten bzw. Schaltabstände der kapazitiven Sensoren und herausragende "sensorische Qualitäten", wie z.B. die Kompensation von Anhaftungen eines Mediums erreichbar. Ein Nachteil dieser oszillatorischen Verfahren besteht jedoch in ihrer hohen Störanfälligkeit für elektrische Wechselfelder in einem mehr oder weniger breitbandigen Bereich um die Schwingungsfrequenz. Derartige Sensoren erfüllen daher in vielen Fällen nicht die EMV-Störfestigkeits-Anforderung, Teil IEC61000-4-6.

Neben den vorbeschriebenen oszillatorischen Verfahren zum Betreiben der Sensoren existieren gewissermaßen "fremdgesteuerte" Verfahren, bei denen ein Generator eine Messschaltung nach verschiedenen Prinzipien steuert, beispielsweise in Form von kapazitiven Brücken, pendelnden Verstärkern, Ladungsbalanceverfahren, Phasenkomparatoren und dergleichen.

Kapazitive Sensoren, die nach diesem Prinzip betrieben werden, gehen beispielsweise aus der DE 199 49 985 A1, aus der DE 197 01 899 C2, aus der EP 1 093 225 B1 oder aus der DE 10 2005 057 558 A1 hervor. Zwar sind kapazitive Sensoren, die auf diese Weise betrieben werden, in vielen Fällen deutlich unempfindlicher gegenüber Störspannungen in einem breiten Frequenzspektrum. Nachteilig ist jedoch, dass derartige Sensoren nur mit einem wesentlich höheren Schaltungsaufwand bei meist geringer sensorischer Qualität realisierbar sind. Als "sensorische Qualität" werden in dieser Anmeldung folgende Größen oder Eigenschaften verstanden:
- ein großer einstellbarer und nutzbarer Empfindlichkeitsbereich, d.h. eine große Spanne zwischen dem minimal und maximal einstellbaren Schaltabstand;
- eine geringe Temperaturabhängigkeit des Schaltabstandes;
- die Fähigkeit der Kompensation feuchter, leitfähiger Anhaftungen bei Füllstandsanwendungen;
- die Serienstabilität bzw. Unabhängigkeit von Bauelementstreuungen.

Bislang existieren keine kapazitiven Sensoren, die diese Eigenschaften bei einer gleichzeitig hohen EMV-Störfestigkeit aufweisen. So wird beispielsweise bei dem aus der DE 10 2005 057 558 A1 hervorgehenden Sensor zur berührungslosen Detektion des Füllstands eines flüssigen und anhaftenden Mediums hoher Leitfähigkeit, beispielsweise Blut, durch eine nicht metallische Behälterwand eines Behälters und dem dort beschriebenen Verfahren zwar eine hervorragende Kompensation von Anhaftungen in Füllstandsanwendungen bei hoher Störfestigkeit erzielt. Dafür erreicht dieser Sensor und das Verfahren zur berührungslosen Detektion des Füllstands von flüssigen Medien keine hohen Schaltabstände, wie sie in der Distanzsensorik gefordert werden.

Bei dem aus der DE 199 45 330 A1 hervorgehenden Verfahren zur Detektion und Auswertung einer Kapazitätsänderung und dem dort beschriebenen Sensor sind zwar beispielsweise hohe Schaltabstände erzielbar und es ist eine Kompensation hoher Störpegel möglich, dieser Sensor erlaubt jedoch keinerlei Kompensation von Anhaftungen ionisierender Medien. US 4,459,541 beschreibt auch eine Schaltungsanordnung zur Bestimmung einer Messkapazität gemäß dem Stand der Technik. Der Erfindung liegt daher die Aufgabe zugrunde, eine Schaltungsanordnung zur Bestimmung einer Messkapazität, insbesondere für den Einsatz in kapazitiven Näherungsschaltern zu vermitteln, welche bei geringem Schaltungsaufwand und hoher Störfestigkeit alle oben genannten sensorischen Qualitäten in hervorragender Weise erfüllt.

### Offenbarung der Erfindung

Diese Aufgabe wird gelöst durch eine Schaltungsanordnung zur Bestimmung einer Messkapazität, die einen Referenzschaltungsteil zum definierten periodischen Auf- und Entladen einer vorgegebenen Referenzkapazität und einen Messschaltungsteil zum definierten periodischen Auf- und Entladen der zu bestimmenden Messkapazität aufweist und die ferner wenigstens einen Schaltungsteil zur Bildung wenigstens einer den zeitlichen Verlauf der Aufladung der Referenzkapazität charakterisierenden Größe und zur Bildung wenigstens einer den zeitlichen Verlauf der Aufladung der Messkapazität charakterisierenden Größe sowie einen Schaltungsteil zum Vergleichen des zeitlichen Verlaufs der die Aufladung der Referenzkapazität charakterisierenden Größe mit dem zeitlichen Verlauf der die Aufladung der Messkapazität charakterisierenden Größe und Schließen auf den Wert der Messkapazität aufgrund dieses Vergleichs umfasst.

Grundidee der Erfindung ist es, die Schaltungsanordnung in zwei Teile, einen Referenzschaltungsteil und einen Messschaltungsteil, aufzuteilen, wobei die Schaltungsteile symmetrisch, also einander entsprechend gleich ausgebildet sind und beide Schaltungsteile jeweils periodisch eine Referenz- bzw. Messkapazität aufladen und jeweils den zeitlichen Verlauf einer die Aufladung charakterisierenden Größe sowohl der Referenz- als auch der Messkapazität erfassen. In einem weiteren Schaltungsteil wird dann aufgrund des Vergleichs die Messkapazität bestimmt. Eine derartige symmetrische Ausbildung des Referenzschaltungsteils und des Messschaltungsteils ermöglicht sehr vorteilhaft eine hohe Störfestigkeit der Schaltungsanordnung, denn sämtliche Störungen, beispielsweise Temperaturschwankungen und dergleichen wirken sich auf beide Schaltungsteile gleich aus, wobei zu bemerken ist, dass diese Schaltungsteile in dem kapazitiven Sensor in unmittelbarer Nähe angeordnet sind, sodass sie im Wesentlichen identischen Umgebungsbedingungen ausgesetzt sind und sich Störungen in beiden Schaltungsteilen gleich auswirken.

Die Auswertung des zeitlichen Verlaufs der die Aufladung charakterisierenden Größe sowohl der Referenzkapazität als auch der Messkapazität erfolgt bevorzugt durch einen Vergleich dieser Größen in dem entsprechenden Schaltungsteil. Immer dann, wenn die den zeitlichen Verlauf der Aufladung der Messkapazität charakterisierende Größe dem zeitlichen Verlauf der die Aufladung der Referenzkapazität charakterisierenden Größe entspricht, wird ein Schaltungssignal ausgegeben. In diesem Falle entspricht der Wert der Messkapazität dem Wert der Referenzkapazität.

Rein prinzipiell wäre es denkbar, sowohl den zeitlichen Verlauf einer die Aufladung der Messkapazität kennzeichnenden Größe als auch den zeitlichen Verlauf einer die Aufladung der Referenzkapazität kennzeichnenden Größe in einem einzigen Schaltungsteil zu erfassen. Eine schaltungstechnisch besonders einfache Realisierung sieht jedoch vor, sowohl dem Referenzschaltungsteil als auch dem Messschaltungsteil jeweils einen eigenen Schaltungsteil zur Erfassung des zeitlichen Verlaufs einer die Aufladung der Messkapazität bzw. der Referenzkapazität charakterisierenden Größe zuzuordnen.

Hinsichtlich der den zeitlichen Verlauf der Aufladung der Messkapazität bzw. der Referenzkapazität kennzeichnenden Größe sind rein prinzipiell die unterschiedlichsten Größen, welche eine Aussage über den zeitlichen Verlauf der Aufladung der Mess- bzw. Referenzkapazität gestatten, denkbar. Gemäß einer besonders vorteilhaften Ausführungsform ist diese Größe beispielsweise das zeitliche arithmetische Mittel oder der Gleichspannungsanteil der Aufladespannung der Mess- bzw. Referenzkapazität.

Gemäß einer besonders vorteilhaften Ausführungsform ist vorgesehen, die Auf- bzw. Entladung der Referenzkapazität und der Messkapazität getaktet periodisch derart vorzunehmen, dass in einem ersten Zeitintervall einer Periode eine simultane Aufladung der Referenzkapazität und der Messkapazität und in einem zweiten Zeitintervall der Periode eine simultane Entladung sowohl der Mess- als auch Referenzkapazität erfolgen.

Dabei ist bevorzugt vorgesehen, dass das zweite Zeitintervall wesentlich kürzer ausgebildet ist als das erste Zeitintervall, sodass die Aufladung wesentlich länger erfolgt als die schlagartige Entladung. Hierdurch wird sichergestellt, dass der Wert des zeitlichen arithmetischen Mittelwerts der Aufladespannung der Mess- bzw. Referenzkapazität bzw. der Gleichtaktanteil des Wechselsignals der Auf- und Entladung der Mess- bzw. Referenzkapazität größere Werte annehmen mit den damit verbundenen Vorteilen der Erfassung dieser Werte. Im Falle der Erfassung des zeitlichen Verlaufs des Mittelwerts der Aufladespannung der Referenz- bzw. Messkapazität ist vorteilhafterweise sowohl in dem Referenzschaltungsteil als auch in dem Messschaltungsteil jeweils wenigstens ein RC-Glied angeordnet. Ein solches RC-Glied erlaubt auf einfache Weise im Falle einer Aufladungskurve, d.h. einer e-Funktion, eine zeitliche arithmetische Mittelwertbildung.

Der Schaltungsteil zum Vergleichen der Mittelwerte und zum Schließen auf die Messkapazität ist bevorzugt ein Komparator, an dessen Eingang die Ausgangssignale der Schaltungsteile zur Mittelwertbildung anliegen.

Um eine simultane Auf- und Entladung sowohl der Mess- als auch der Referenzkapazität mit hoher Präzision zu erreichen, ist gemäß einer Ausführungsform vorgesehen, dass das periodische Auf- und Entladen durch einen Taktgenerator erfolgt, der eine Schalteranordnung ansteuert, die simultan die Referenzkapazität und die Messkapazität mit Masse verbindet. Dabei ist - wie oben erwähnt - das Zeitintervall, in dem die Referenz- bzw. Messkapazität mit Masse verbunden sind, wesentlich kürzer ist als die Zeit, in der die Schalteranordnung jeweils geöffnet ist, d.h. eine Aufladung der Referenz- bzw. Messkapazität erfolgt.

Die Schalteranordnung wird bevorzugt durch ein Diodennetzwerk oder Junction-FETs realisiert, die besonders störunempfindlich sind bei gleichzeitig sehr präzisen Schalteigenschaften. Insbesondere entstehen hierdurch im Vergleich zu integrierten Analogschaltern sehr vorteilhaft nur geringe parasitäre Kapazitäten, die beispielsweise bei der aus der DE 197 01 899 C2 hervorgehenden Schaltung, die mit Umschaltern, also jeweils zwei Schaltern und somit doppelter parasitärer Belastung der Messkapazität arbeitet, auftreten können.

Besonders bevorzugt ist vorgesehen, dass die Aufladung der Referenzkapazität mit einer einstellbaren Spannungsquelle erfolgt, wohingegen die Aufladung der Messkapazität mit einer festen Kleinspannungsquelle erfolgt. Auf diese Weise kann bei einem kapazitiven Sensor der Schaltabstand eingestellt werden, wie weiter unten noch näher erläutert wird.

Der Referenzschaltungsteil und der Messschaltungsteil sind bevorzugt innerhalb des gleichen Gehäuses in unmittelbarer Nachbarschaft zueinander, insbesondere auf der gleichen Leiterplatte angeordnet, um so die Kompensation von linearen Störeinflüssen, beispielsweise Temperatureinflüssen oder Einflüssen aufgrund von Bauteiledrifts sehr vorteilhaft kompensieren zu können, denn diese Störeinflüsse wirken sich auf beide symmetrisch ausgebildeten Schaltungsteile gleich aus.

### Zeichnungen

Weitere Vorteile und Merkmale der Erfindung sind Gegenstand der nachfolgenden Beschreibung sowie der zeichnerischen Darstellung von Ausführungsbeispielen.

In den Zeichnungen zeigen:
- Fig. 1: ein erstes Ausführungsbeispiel einer erfindungsgemäßen Schaltungsanordnung;
- Fig. 2: schematisch die Ladespannungen der Referenz- und Messkapazität und deren Auswertung;
- Fig. 3: ein zweites Ausführungsbeispiel einer erfindungsgemäßen Schaltungsanordnung;
- Fig. 4: ein drittes Ausführungsbeispiel einer erfindungsgemäßen Schaltungsanordnung und
- Fig. 5: ein weiteres Ausführungsbeispiel einer erfindungsgemäßen Schaltungsanordnung.

### Beschreibung von Ausführungsbeispielen

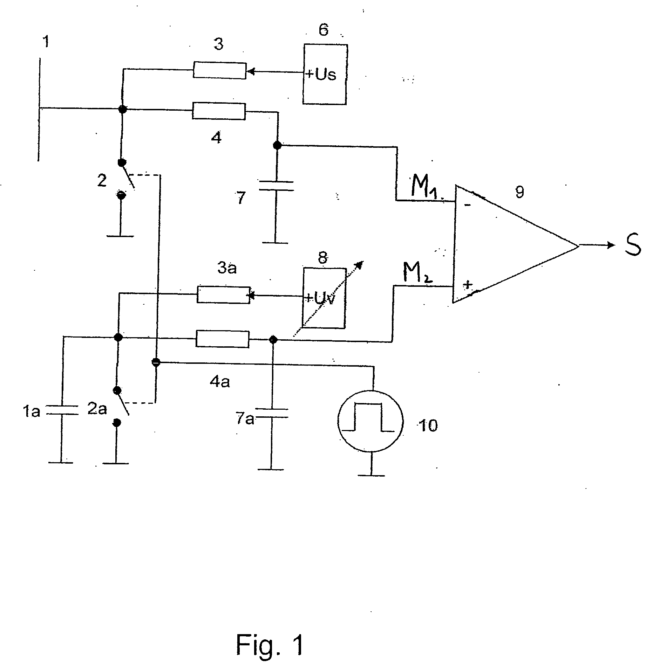

Ein erstes Ausführungsbeispiel einer erfindungsgemäßen Schaltungsanordnung ist in Fig. 1 dargestellt. Elektronische Schalter 2, 2a werden von einem Rechteckgenerator 10 mit einer Steuerfrequenz 1/(Ton + Toff) periodisch für eine Zeit Ton eingeschaltet und für eine Zeit Toff ausgeschaltet. Während der Zeit Ton werden eine Messkapazität bzw. Messelektrode 1 bzw. eine feste Referenzkapazität 1a durch die Schalter 2 bzw. 2a mit einem festen Potenzial, hier beispielsweise Masse, verbunden. Hierdurch entladen sich die Messkapazität 1 und die Referenzkapazität 1a schlagartig. Nach Ablauf dieser Zeit Ton öffnen die Schalter 2 bzw. 2a. Die Kapazitäten 1 und 1a werden über die jeweils zugeordneten Widerstände 3 bzw. 3a aufgeladen. Hierbei werden Ladeströme durch eine feste Gleichspannungsquelle U_{S} 6, die beispielsweise durch eine stabilisierte interne Sensorversorgung realisiert werden kann, und eine einstellbare Gleichspannungsquelle U_{V} 8 zugeführt. Die Ladespannungen an den Kapazitäten 1 bzw. 1a steigen gemäß einer e-Funktion, welche die Aufladefunktion einer Kapazität darstellt, an. Der Spannungsanstieg ist dabei direkt abhängig von der Größe der Kapazitäten, von der Größe der Ladewiderstände bzw. Ladeströme und von den Speisespannungen. Bei geeigneter Dimensionierung wird die maximale Ladespannung U_{Lend} nach Ablauf des Zeitintervalls Toff nicht erreicht, bevor die Kapazitäten wieder durch Schließen der Schalter 2 bzw. 2a während des Zeitintervalls Ton schlagartig entladen werden. Das Auf- und Entladen setzt sich im Takt des Generators 10 fort.

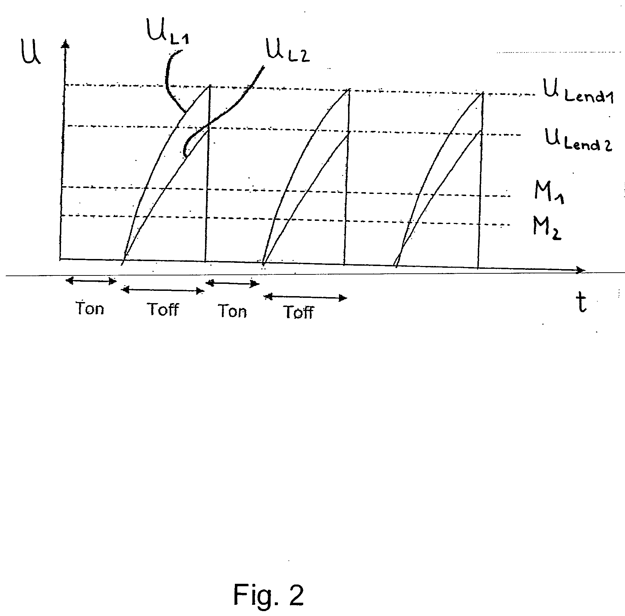

Die Signalverläufe sind schematisch in Fig. 2 dargestellt. Aus den periodischen Signalverläufen, die sich an den Kapazitäten in Form der Spannungen U_{L1}, der Ladespannung der Messkapazität, und U_{L2}, der Ladespannung der Referenzkapazität, einstellen, wird auf nachfolgend beschriebene Weise auf den Wert der Messkapazität 1 geschlossen. Hierzu ist eine Mittelwertbildung der Ladespannungen D_{L1} bzw. U_{L2} der Messkapazität 1 bzw. der Referenzkapazität 1a vorgesehen. Diese Mittelwertbildung wird durch RC-Tiefpässe erster Ordnung, gebildet durch Widerstände 4 bzw. 4a und Kapazitäten 7 bzw. 7a realisiert, welche den arithmetischen Mittelwert bzw. den Gleichspannungsanteil des Wechselsignals gewissermaßen heraussieben. Die Widerstände 4 bzw. 4a sollten dabei zur guten Entkoppelung vom Lade- und Entladevorgang vorzugsweise mindestens fünfmal größer als die Widerstände 3 bzw. 3a sein.

Grundidee der Erfindung ist diese Mittelwertbildung der Auf- und Entladekurven an den beiden Kapazitäten: Messkapazität und Referenzkapazität. Die Mittelwerte bzw. Gleichspannungsanteile der Ladespannungen sind dabei jeweils umkehrbar eindeutig den erreichten Ladeendspannungen zugeordnet, wie in Fig. 2 ersichtlich, wo der Ladespannung U_{L1} ein Mittelwert M₁ und der Ladespannung U_{L2} ein Mittelwert M₂ zugeordnet sind. Diese Signale M₁ und M₂ werden einem Spannungskomparator 9 zugeführt. Die Spannung am "-"-Eingang wird dabei direkt von der Messgröße beeinflusst. Sie sinkt mit Zunahme der Kapazität 1, was ein Sinken der Ladeentspannung U_{Lend1} und somit des Mittelwertes M₁ zur Folge hat. Unterschreitet dieses Signal am "-"-Eingang des Komparators 9 das Signal M₂ des Mittelwerts der Ladespannung der Referenzkapazität, die im Referenzschaltungsteil gebildet wird und am "+"-Eingang des Komparators 9 anliegt, kippt der Komparator 9 vom Low- in den High-Zustand und gibt z.B. ein Signal S aus, das beispielsweise die Erfassung eines Mediums anzeigt. Je näher der Wert des Mittelwerts M₂ an dem Wert des Mittelwerts M₁ liegt, desto geringer ist der Grenzwert der Messkapazität 1, ab welcher der Komparator 9 kippt. Die Einstellung der Empfindlichkeit kann in einem weiten Bereich durch die einstellbare Gleichspannung U_{V} mittels der einstellbaren Spannungsquelle 8 erfolgen.

Der Referenzschaltungsteil, der symmetrisch zum Messschaltungsteil, also gewissermaßen gegengleich zum Messschaltungsteil aufgebaut ist, ist in Figur 1 jeweils mit dem Bezugszeichen-Zusatz "a" gekennzeichnet.

Durch den symmetrischen, also gleich ausgebildeten Aufbau der beiden Schaltungsteile treten bauteilbedingte Drifts, z.B. Temperaturdrifts oder Drifts aufgrund der Alterung von Bauteilen in beiden Zweigen gleich auf. Gleiches Driften in beiden Zweigen ergibt insoweit eine theoretische Differenzspannung null. Hierdurch werden Drifterscheinungen weitestgehend eliminiert. Die Schaltungsanordnung weist aus diesem Grunde eine sehr geringe Temperaturabhängigkeit und damit eine sehr große erreichbare Empfindlichkeit auf. Die sensorische Qualität der vorbeschriebenen Schaltungsanordnung wird im Wesentlichen durch die Eigenschaften der elektronischen Schalter 2 und besonders durch deren parasitäre Kapazitäten bestimmt. Die Schalter können z.B. mit Junction-FETs oder Diodennetzwerken kostengünstig realisiert werden. Die hohe Störfestigkeit beruht auf der Tatsache, dass sich in einem linearen System viele Signale ungestört überlagern. Bei offenem Schalter 2 während des Zeitintervalls Toff liegen nur Widerstände, also lineare Bauteile an der Elektrode 1 an. Der Mittelwert von ausgekoppelten Störspannungen nach den RC-Tiefpässen 4, 7 bzw. 4a, 7a ist immer gleich null. Voraussetzung hierfür ist, dass die elektronische Schalteranordnung 2, 2a im geöffneten Zustand große Störspannungshübe am Elektrodenanschluss nicht begrenzt. Dies wird durch ausreichende Sperrspannungen in einem Diodenschalternetzwerk oder den Einsatz von Junction-FETs, die eine negative Sperrspannung aufweisen, erreicht. Während des Zeitintervalls Ton ist die Messelektrode 1 auf ein festes Potenzial gelegt und somit auch in diesem Zeitabschnitt nicht störbar.

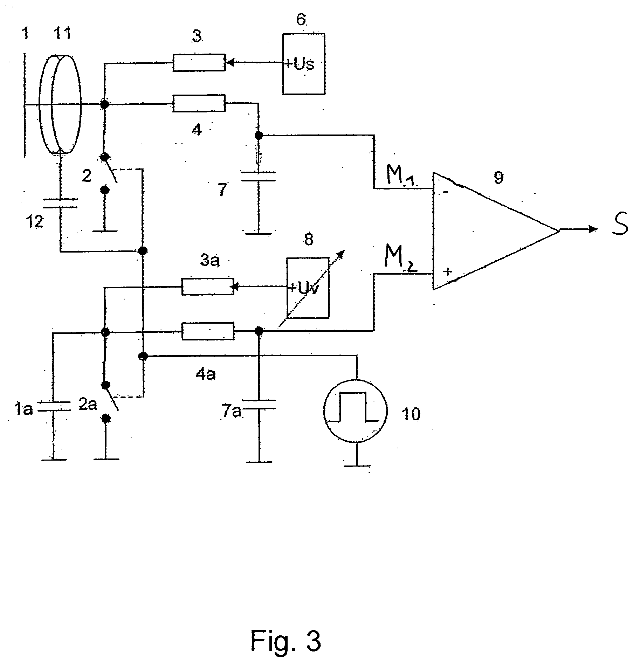

Eine weitere Ausführungsform der Schaltungsanordnung wird nachfolgend in Verbindung mit Fig. 3 beschrieben, wobei gleiche Elemente in Fig. 3 mit den gleichen Bezugszeichen wie in Fig. 1 bezeichnet sind, sodass bezüglich deren Beschreibung auf das Vorstehende vollinhaltlich Bezug genommen wird. Die Schaltungsanordnung in Fig. 3 unterscheidet sich von der in Fig. 2 dadurch, dass die Messelektrode 1 von einer ringförmigen Kompensationselektrode 11 umgeben ist. Diese Kompensationselektrode 11 hat die Aufgabe, Störeinflüsse, die durch kapazitive Einflüsse beispielsweise eines Kunststoffgehäuses, in dem die Schaltungsanordnung und der Sensor verbaut sind, hervorgerufen werden, auf die Messelektrode 1 zu minimieren. Die Kompensationselektrode 11 wirkt insoweit Störeinflüssen, beispielsweise äußeren Anhaftungen eines Mediums am Sensorgehäuse nach Eintauchen und Herausziehen bei einer Füllstandsabfrage durch ein kompensierendes Wechselfeld entgegen. Diese Schaltungsanordnung kommt insbesondere in Freizonenanwendung zum Einsatz.

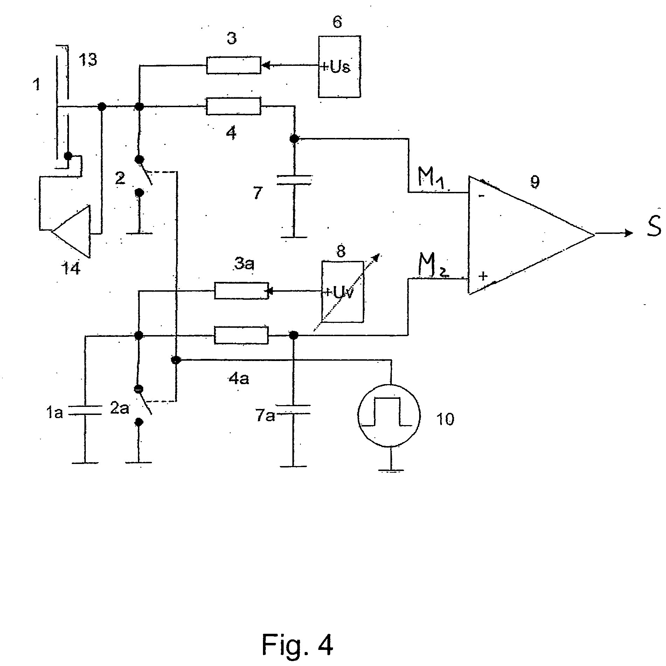

Das in Fig. 4 dargestellte Ausführungsbeispiel unterscheidet sich von dem in Fig. 1 dargestellten dadurch, dass die Messelektrode 1 von einer Schirmelektrode 13 umgeben ist. Auch hier sind wiederum gleiche Elemente mit den gleichen Bezugszeichen bezeichnet wie in Fig. 1, sodass bezüglich deren Beschreibung auf das Vorstehende Bezug genommen wird. Die Schirmelektrode 13 dient der rückwärtigen Abschirmung der Messelektrode 1 und ist insoweit unmittelbar rückseitig der Messelektrode angeordnet bzw. umgibt die Messelektrode rückseitig. Die Schirmelektrode 13 ist von einem nichtinvertierenden Verstärker 14 mit dem Spannungsverstärkungsfaktor 1 und möglichst hochimpedantem Eingang und niederimpedantem Ausgang gepuffert.

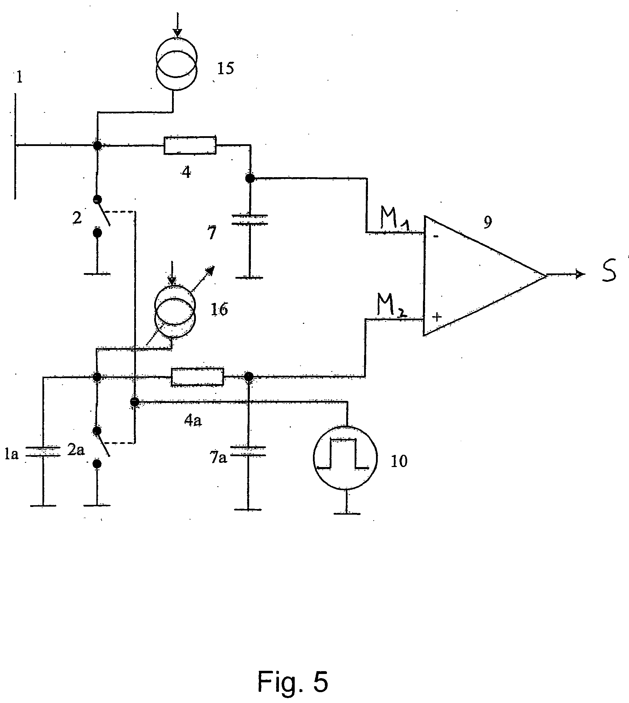

Ein weiteres Ausführungsbeispiel einer erfindungsgemäßen Schaltung ist in Fig. 5 dargestellt, wobei auch hier wiederum gleiche Elemente mit den gleichen Bezugszeichen wie in Fig. 1 und Fig. 2 versehen sind, sodass bezüglich deren Beschreibung auf das Vorstehende Bezug genommen wird. Die Schaltungsanordnung in Fig. 5 unterscheidet sich von den in Fig. 1 bis Fig. 4 dargestellten dadurch, dass anstelle der Spannungsquelle 6 und des Widerstands 3 eine feste Gleichstromquelle 15 und anstelle der Spannungsquelle 8 und des Widerstands 3a eine einstellbare Gleichstromquelle 16 vorgesehen sind. Bei dieser Schaltungsanordnung erfolgt die Aufladung der Messkapazität 1 bzw. der Referenzkapazität 1a über diese konstanten Stromquellen 15 und 16 nicht gemäß einer e-Funktion, sondern zeitlich linear.

Darüber hinaus ist hervorzuheben, dass vorbeschriebene Schaltungsanordnungen auch so ausgelegt sein können, dass sämtliche Polaritäten vertauscht sein können, das heißt während der Zeit Toff könnten die Kapazitäten 1 und 1a auch zum Beispiel über negative Spannungsquellen 6 bzw. 8 oder Stromsenken anstelle der konstanten Stromquellen 15 und 16 entladen und während einer Zeit Ton schlagartig auf einen positiven Wert aufgeladen werden. Auch hierdurch lässt sich das vorbeschriebene Prinzip der Erfindung realisieren.

## Patentansprüche

1. Schaltungsanordnung zur Bestimmung einer Messkapazität (1), umfassend einen Referenzschaltungsteil zum definierten periodischen Auf- und Entladen einer vorgegebenen Referenzkapazität (1a) und einen Messschaltungsteil zum definierten periodischen Auf- und Entladen der zu bestimmenden Messkapazität (1) und wenigstens einen Schaltungsteil (4, 7; 4a, 7a) zur Bildung wenigstens einer, den zeitlichen Verlauf der Aufladung der Referenzkapazität (1a) charakterisierenden Größe (M₂) und zur Bildung wenigstens einer, den zeitlichen Verlauf der Aufladung der Messkapazität (1) charakterisierenden Größe (M₁) und einen Schaltungsteil (9) zum Vergleichen der wenigstens einen, den zeitlichen Verlauf der Aufladung der Referenzkapazität (1a) charakterisierenden Größe (M₂) mit der wenigstens einen, den zeitlichen Verlauf der die Aufladung der Messkapazität (1) charakterisierenden Größe (M₁) und zum Schließen auf den Wert der Messkapazität (1) aufgrund des Vergleichs.

2. Schaltungsanordnung nach Anspruch 1, **dadurch gekennzeichnet, dass** sowohl dem Referenzschaltungsteil als auch dem Messschaltungsteil jeweils ein eigener Schaltungsteil (4, 7; 4a, 7a) zur Bildung wenigstens einer Größe zugeordnet ist,die den zeitlichen Verlauf der wenigstens einen Aufladung der Referenzkapazität bzw. der Messkapazität charakterisiert.

3. Schaltungsanordnung nach Anspruch 1 oder 2, **dadurch gekennzeichnet, dass** der Schaltungsteil (4a, 7a) zur Bildung der wenigstens einen, den zeitlichen Verlauf der Aufladung der Referenzkapazität (1a) charakterisierenden Größe (M₂) den arithmetischen Mittelwert bzw. den Gleichspannungsanteil der Aufladespannung der Referenzkapazität (1a) bildet und dass der Schaltungsteil (4, 7) zur Bildung der wenigstens einen, den zeitlichen Verlauf der Aufladung der Messkapazität (1) charakterisierenden Größe (M₁) den arithmetischen Mittelwert bzw. den Gleichspannungsanteil der Aufladespannung der Messkapazität (1) bildet.

4. Schaltungsanordnung nach einem der Ansprüche 1 bis 3, **dadurch gekennzeichnet, dass** die Auf- und Entladung der Referenzkapazität (1a) und der Messkapazität (1) getaktet periodisch derart erfolgt, dass in einem ersten Zeitintervall (Toff) eine simultane Aufladung der Referenzkapazität (1a) und der Messkapazität (1) und in einem zweiten Zeitintervall (Ton) eine schlagartige Entladung der Referenz- bzw. Messkapazität erfolgen.

5. Schaltungsanordnung nach Anspruch 4, **dadurch gekennzeichnet, dass** sich das erste Zeitintervall (Toff) von dem zweiten Zeitintervall (Ton) unterscheidet.

6. Schaltungsanordnung nach Anspruch 5, **dadurch gekennzeichnet, dass** das erste Zeitintervall (Toff) größer ist als das zweite Zeitintervall (Ton).

7. Schaltungsanordnung nach einem der Ansprüche 3 bis 6, **dadurch gekennzeichnet, dass** der dem Referenzschaltungsteil zugeordnete Schaltungsteil zur Bildung des arithmetischen Mittelwerts (M₂) des zeitlichen Verlaufs der Aufladespannung der Referenzkapazität (1a) wenigstens ein erstes RC-Glied (4a, 7a) ist und dass der dem Messschaltungsteil zugeordnete Schaltungsteil zur Bildung des arithmetischen Mittelwerts (M₁) des zeitlichen Verlaufs der Aufladespannung der Messkapazität (1) wenigstens ein zweites RC-Glied (4, 7) ist.

8. Schaltungsanordnung nach einem der vorstehenden Ansprüche, **dadurch gekennzeichnet, dass** der Schaltungsteil zum Vergleichen der wenigstens einen, den zeitlichen Verlauf der Aufladung der Messkapazität (1) kennzeichnenden Größe (M₁) mit der, den zeitlichen Verlauf der Aufladung der Referenzkapazität (1a) kennzeichnenden Größe (M₂) und zum Schließen auf die Messkapazität (1) ein Komparator (9) ist, an dessen Eingang die Ausgangssignale der Schaltungsteile zur Bildung der wenigstens einen, den zeitlichen Verlauf der Aufladung der Referenzkapazität (1a) kennzeichnenden Größe (M₂) und zur Bildung der wenigstens einen, den zeitlichen Verlauf der Messkapazität (1) kennzeichnenden Größe (M₁) anliegen.

9. Schaltungsanordnung nach einem der vorstehenden Ansprüche, **dadurch gekennzeichnet, dass** das periodische Auf- und Entladen durch einen Taktgenerator (10) erfolgt, der eine Schalteranordnung (2, 2a) ansteuert, die simultan die Referenzkapazität (1a) und die Messkapazität (1) mit Masse verbindet.

10. Schaltungsanordnung nach Anspruch 9, **dadurch gekennzeichnet, dass** die Grenzfrequenz der RC-Glieder zur Mittelwertbildung (4, 7; 4a, 7a) kleiner als die Taktfrequenz des Generators (10), vorzugsweise kleiner als 1/100 der Taktfrequenz des Generators (10) ist.

11. Schaltungsanordnung nach Anspruch 9 oder 10, **dadurch gekennzeichnet, dass** die Schalteranordnung (2, 2a) durch ein Diodennetzwerk oder durch Junction-FETs gebildet wird.

12. Schaltungsanordnung nach einem der vorstehenden Ansprüche, **dadurch gekennzeichnet, dass** die Aufladung der Referenzkapazität (1a) mit einer einstellbaren Spannungsquelle (8) erfolgt und dass die Aufladung der Messkapazität mit einer festen Gleichspannungsquelle (6) erfolgt.

13. Schaltungsanordnung nach Anspruch 12, **dadurch gekennzeichnet, dass** anstelle der Spannungsquelle (6) und eines Widerstands (3) eine feste Gleichstromquelle (15) und anstelle der Spannungsquelle (8) und eines Widerstands (3a) eine einstellbare Gleichstromquelle vorgesehen sind und die Aufladung der Messkapazität (1) und der Referenzkapazität (1a) jeweils über diese Konstantstromquellen (15) und (16) zeitlich linear erfolgt.

14. Schaltungsanordnung nach einem der vorstehenden Ansprüche, **dadurch gekennzeichnet, dass** in unmittelbarer räumlicher Nähe zur Messelektrode (1) eine insbesondere ringförmige Kompensationselektrode (11) angeordnet ist, die zusammen mit der Messelektrode periodisch getaktet auf- und entladen wird.

15. Schaltungsanordnung nach einem der vorstehenden Ansprüche, **dadurch gekennzeichnet, dass** zur rückwärtigen Abschirmung der Messelektrode (1) eine Schirmelektrode (13) unmittelbar benachbart zur Messelektrode (1) rückseitig dieser und diese vorzugsweise becherförmig umgebend angeordnet ist, die von einem nichtinvertierenden Verstärker (14) mit dem Spannungsverstärkungsfaktor 1 und hochimpedantem Eingang und niederimpedantem Ausgang gepuffert ist.

16. Schaltungsanordnung nach einem der vorstehenden Ansprüche, **dadurch gekennzeichnet, dass** alle Schaltungsteile in einem einzigen Gehäuse, insbesondere auf einer einzigen Leiterplatte angeordnet sind.

17. Schaltungsanordnung nach einem der vorstehenden Ansprüche, **dadurch gekennzeichnet, dass** der Referenzschaltungsteil und der Messschaltungsteil symmetrisch zueinander aufgebaut sind.

## Claims

1. Circuit arrangement for determination of a measuring capacitance (1), comprising a reference circuit portion for defined periodic charging and discharging of a predefined reference capacitance (1a), and a measuring circuit portion for defined periodic charging and discharging of the measuring capacitance (1) to be determined, and at least one circuit portion (4, 7; 4a, 7a) intended to determine at least one value (M₂) characteristic of the charging time curve of the reference capacitance (1a) and for deriving at least one value (M₁) characteristic of the charging time curve of the measuring capacitance (1), as well as a circuit portion (9) for comparing the at least one value (M₂) characteristic of the charging time curve of the reference capacitance (1a) with the at least one value (M₁) characteristic of the charging time curve of the measuring capacitance (1), and for deriving from that comparison the value of the measuring capacitance (1).

2. The circuit arrangement according to Claim 1, **characterized in that** each of the reference circuit portion and the measuring circuit portion are assigned a separate circuit part (4, 7; 4a, 7a) intended to determine at least one value characteristic of the time curve of at least one charging cycle of the measuring capacitance and of the reference capacitance, respectively.

3. The circuit arrangement according to Claim 1 or Claim 2, **characterized in that** the circuit portion (4a, 7a) intended to form the at least one value (M₂) characteristic of the charging time curve of the reference capacitance (1a) forms the arithmetic mean value or the direct-voltage content of the charging voltage of the reference capacitance (1a) and that for forming the at least one value (M₁) characteristic of the charging time curve of the measuring capacitance (1) the circuit portion (4, 7) forms the arithmetic mean value or the direct-voltage content, respectively, of the charging voltage of the measuring capacitance (1).

4. The circuit arrangement according to any of Claims 1 to 3, **characterized in that** charging or discharging of the reference capacitance (1a) and of the measuring capacitance (1) occur periodically and in cycle-controlled fashion so that simultaneous charging of the reference capacitance (1a) and the measuring capacitance (1) occur in a first time interval (Toff) and abrupt discharging of the reference capacitance and the measuring capacitance, respectively, occur in a second time interval (Ton).

5. The circuit arrangement according to Claim 4, **characterized in that** the first time interval (Toff) differs from the second time interval (Ton).

6. The circuit arrangement according to Claim 5, **characterized in that** the first time interval (Toff) is greater than the second time interval (Ton).

7. The circuit arrangement according to any of Claims 3 to 6, **characterized in that** the circuit part assigned to the reference circuit portion for forming the arithmetic mean value (M₂) of the time curve of the charging voltage of the reference capacitance (1a), is at least one first RC element (4a, 7a) and that the circuit part assigned to the measuring circuit portion for forming the arithmetic mean value (M₁) of the time curve of the charging voltage of the measuring capacitance (1) is at least one second RC element (4, 7).

8. The circuit arrangement according to any of the preceding claims, **characterized in that** the circuit portion intended to compare the at least one value (M₁) characteristic of the charging time curve of the measuring capacitance (1) with the value (M₂) characteristic of the charging time curve of the reference capacitance (1a), and for determining from that comparison the measuring capacitance (1) is a comparator (9) whose input is supplied with the output signals of the circuit parts for forming the at least one value (M₂) characteristic of the charging time curve of the reference capacitance (1a) and for forming the at least one value (M₁) characteristic of the time curve of the measuring capacitance (1).

9. The circuit arrangement according to any of the preceding claims, **characterized in that** periodic charging and discharging is effected via a clock-pulse generator (10) that drives a switch arrangement (2, 2a) which simultaneously connects to ground the reference capacitance (1a) and the measuring capacitance (1).

10. The circuit arrangement according to Claim 9, **characterized in that** the limit frequency of the RC elements intended to form the mean value (4, 7; 4a, 7a) is smaller than the clock-pulse frequency of the generator (10), preferably smaller than 1/100 of the clock-pulse frequency of the generator (10).

11. The circuit arrangement according to Claim 9 or Claim 10, **characterized in that** the switch arrangement (2, 2a) is formed by a diode network or by junction FETs.

12. The circuit arrangement according to any of the preceding claims, **characterized in that** charging of the reference capacitance (1a) is effected via an adjustable voltage source (8) and that charging of the measuring capacitance is effected via a fixed direct-voltage source (6).

13. The circuit arrangement according to Claim 12, **characterized in that** a fixed d.c. source (15) is provided instead of the voltage source (6) and a resistor 3, and that an adjustable d.c. source is provided instead of the voltage source (8) and a resistor (3a) and that charging of the measuring capacitance (1) and of the reference capacitance (1a) is effected linearly in time via those constant current sources (15) and (16), respectively.

14. The circuit arrangement according to any of the preceding claims, **characterized in that** a compensation electrode, especially an annular compensation electrode (11), is arranged in the immediate neighborhood of the measuring electrode (1), which is charged and discharged together with the measuring electrode periodically and in a cycle-controlled fashion.

15. The circuit arrangement according to any of the preceding claims, **characterized in that** for shielding the measuring electrode (1) at its rear, a shielding electrode (13) is arranged in the immediate neighborhood of the measuring electrode (1), at its rear and preferably so as to enclose it like a cup, which is buffered by a non-inverting amplifier (14) having a voltage amplifying factor 1 and a high-impedance input and a low-impedance output.

16. The circuit arrangement according to any of the preceding claims, **characterized in that** all parts of the circuit are arranged in a single housing, especially on a single printed board.

17. The circuit arrangement according to any of the preceding claims, **characterized in that** the reference circuit portion and the measuring circuit portion have a symmetrical design one relative to the other.

## Revendications

1. Circuit destiné à la détermination d'une capacité de mesure (1), comprenant une partie de circuit de référence destinée à la charge et à la décharge périodique définie d'une capacité de référence (1a) prédéterminée et une partie de circuit de mesure destinée à la charge et à la décharge périodique définie de la capacité de mesure (1) à déterminer et au moins une partie de circuit (4, 7 ; 4a, 7a) destinée à l'élaboration d'une grandeur (M₂) caractérisant l'évolution dans le temps de la charge de la capacité de référence (1a) et à l'élaboration d'au moins une grandeur (M₁) caractérisant l'évolution dans le temps de la capacité de mesure (1), et une partie de circuit (9) destinée à la comparaison de l'au moins une grandeur (M₂) caractérisant l'évolution dans le temps de la charge de la capacité de référence (1a) avec l'au moins une grandeur (M₁) caractérisant l'évolution dans le temps de la charge de la capacité de mesure (1) et destinée à la déduction de la valeur de la capacité de mesure (1) sur la base de la comparaison.

2. Circuit selon la revendication 1, **caractérisé en ce qu'**une partie de circuit (4, 7 ; 4a, 7a) propre est respectivement associée chaque fois à la partie de circuit de référence et à la partie de circuit de référence destinée à l'élaboration d'au moins une grandeur qui caractérise l'évolution dans le temps de l'au moins une charge de la capacité de référence, respectivement, de la capacité de mesure.

3. Circuit selon la revendication 1 ou 2, **caractérisé en ce que** la partie de circuit (4a, 7a) destinée à l'élaboration de l'au moins une grandeur (M₂) caractérisant l'évolution dans le temps de la charge de la capacité de référence (1a) constitue la valeur moyenne arithmétique, respectivement, la composante de tension continue de la tension de charge de la capacité de référence (1a), et que la partie de circuit (4, 7) destinée à l'élaboration de l'au moins une grandeur (M₁) caractérisant l'évolution dans le temps de la charge de la capacité de mesure (1) constitue la valeur moyenne arithmétique, respectivement, la composante de tension continue de la tension de charge de la capacité de mesure (1).

4. Circuit selon l'une des revendications 1 à 3, **caractérisé en ce que** la charge et la décharge de la capacité de référence (1a) et de la capacité de mesure (1) a lieu à une cadence périodique de telle sorte que dans un premier intervalle de temps (Toff), une charge simultanée de la capacité de référence (1a) et de la capacité de mesure (1) a lieu et dans un deuxième intervalle de temps (Ton) une décharge par à-coups de la capacité de référence, respectivement de la capacité de mesure, a lieu.

5. Circuit selon la revendication 4, **caractérisé en ce que** le premier intervalle de temps (Toff) se différentie du deuxième intervalle de temps (Ton).

6. Circuit selon la revendication 5, **caractérisé en ce que** le premier intervalle de temps (Toff) est plus grand que le deuxième intervalle de temps (Ton).

7. Circuit selon l'une des revendications 3 à 6, **caractérisé en ce que** la partie de circuit associée à la partie de circuit de référence destinée à l'élaboration de la valeur moyenne (M₂) arithmétique de l'évolution dans le temps de la tension de charge de la capacité de référence (1a) est au moins un premier circuit RC (4a, 7a) et que la partie de circuit associée à la partie de circuit de mesure destinée à l'élaboration de la valeur moyenne (M₁) arithmétique de l'évolution dans le temps de la tension de charge de la capacité de mesure (1) est au moins un deuxième circuit RC (4, 7).

8. Circuit selon l'une des revendications précédentes, **caractérisé en ce que** la partie de circuit destinée à la comparaison de l'au moins une grandeur (M₁) caractérisant l'évolution dans le temps de la charge de la capacité de mesure (1) avec la grandeur (M₂) caractérisant l'évolution dans le temps de la charge de la capacité de référence (1a) et destinée à la déduction de la capacité de mesure (1) est un comparateur (9), à l'entrée duquel les signaux de sortie des parties de circuit destinées à l'élaboration de l'au moins une grandeur (M₂) caractérisant l'évolution dans le temps de la charge de la capacité de référence (1a) et à l'élaboration de l'au moins une grandeur (M₁) caractérisant l'évolution dans le temps de la capacité de mesure (1) sont présents.

9. Circuit selon l'une des revendications précédentes, **caractérisé en ce que** la charge et la décharge périodiques s'effectuent par un générateur de cadence (10) qui commande un agencement de commutateurs (2, 2a) qui relie simultanément la capacité de référence (1a) et la capacité de mesure (1) avec la masse.

10. Circuit selon la revendication 9, **caractérisé en ce que** la fréquence de coupure des circuits RC destinés à l'élaboration de la valeur moyenne (4, 7 ; 4a, 7a) est inférieure à la fréquence de cadence du générateur (10), de préférence, inférieure d'un équivalent de 1/100 de la fréquence de cadence du générateur (10).

11. Circuit selon la revendication 9 ou 10, **caractérisé en ce que** l'ensemble de commutateurs (2, 2a) est formé par un réseau de diodes ou par un transistor de type Junction-FET.

12. Circuit selon l'une des revendications précédentes, **caractérisé en ce que** la charge de la capacité de référence (1a) a lieu avec une source de tension (8) réglable et que la charge de la capacité de mesure a lieu avec une source de tension continue (6) fixe.

13. Circuit selon la revendication 12, **caractérisé en ce qu'**à la place de la source de tension (6) et d'une résistance (3), une source de courant continu (15) fixe est prévue et qu'à la place de la source de tension (8) et d'une résistance (3a), une source de courant continu réglable est prévue et que la charge de la capacité de mesure (1) et de la capacité de référence (1a) a lieu respectivement de manière linéaire dans le temps et par le biais de ces sources de courant constant (15) et (16).

14. Circuit selon l'une des revendications précédentes, **caractérisé en ce qu'**à proximité spatiale immédiate de l'électrode de mesure (1) est disposée une électrode de compensation (11), de préférence de forme annulaire, qui, conjointement avec l'électrode de mesure est chargée et déchargée en cadence périodiquement.

15. Circuit selon l'une des revendications précédentes, **caractérisé en ce que**, pour un blindage électromagnétique de l'arrière de l'électrode de mesure (1), une électrode de blindage (13) est disposée à proximité immédiate de l'électrode de mesure (1), à l'arrière de celle-ci et de préférence que celle-ci l'entoure sous la forme d'un bol, qui est amortie par un amplificateur (14) non inverseur doté d'un facteur d'amplification de tension de 1 et d'une entrée d'impédance élevée et d'une sortie de faible impédance.

16. Circuit selon l'une des revendications précédentes, **caractérisé en ce que** toutes les parties de circuit sont disposées dans un seul boîtier, en particulier sur un seul circuit imprimé.

17. Circuit selon l'une des revendications précédentes, **caractérisé en ce que** la partie de circuit de référence et la partie de circuit de mesure sont montées symétriquement l'une par rapport à l'autre.
